# EUROPÄISCHE PATENTSCHRIFT

(11) **EP 0 953 154 B1**
(45) Veröffentlichungstag und Bekanntmachung des Hinweises auf die Patenterteilung: **11.09.2002**
(21) Anmeldenummer: 97953664.6
(22) Anmeldetag: 20.12.1997
(51) Int. Cl.: G01R 31/26, G01R 31/02

(54) **VORRICHTUNGEN UND VERFAHREN ZUR DETEKTION VON LEITERBAHNUNTERBRECHUNGEN BEI SOLARMODULEN**
DEVICE AND METHOD FOR DETECTING CONDUCTOR BREAKS IN SOLAR MODULES
DISPOSITIF ET PROCEDE DE DETECTION DE RUPTURE DE CONDUCTEUR DANS LES MODULES SOLAIRES

(30) Priorität: 15.01.1997 DE 19701152
(43) Veröffentlichungstag der Anmeldung: 03.11.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: SCHMIDT, Heribert, D-79312 Emmendingen (DE)
(74) Vertreter: Rackette, Karl
(86) Internationale Anmeldenummer: DE9703003
(87) Internationale Veröffentlichungsnummer: WO98032024

(56) Entgegenhaltungen:
- DE-U- 9 312 710
- US-A- 4 473 796
- US-A- 4 695 788

## Beschreibung

Die Erfindung betrifft eine Vorrichtung zur Detektion von Leiterbahnunterbrechungen bei Solarmodulen mit einem wenigstens eine an Solarmodule induktiv ankoppelbare Induktivität sowie Mittel zur Schwingungsanregung ausweisenden Resonanzkreis und mit einem an den Resonanzkreis gekoppelten Meßwertwandler.

Die Erfindung betrifft weiterhin ein Verfahren zur Detektion von Leiterbahnunterbrechungen bei Solarmodulen, bei dem ein Resonanzkreis induktiv mit einem Solarmodul gekoppelt wird.

Bei aus einzelnen über Leiterbahnen miteinander verbundenen Solarzellen aufgebauten Solarmodulen kommt es trotz deren im allgemeinen hohen Zuverlässigkeit zu Unterbrechungen in den Leiterbahnen, die zu einer Unbrauchbarkeit des Solarmodules und in ungünstigen Fällen zu einer Zerstörung des mechanischen Aufbaus infolge starker Wärmeentwicklung führen können. Neben einer Endkontrolle von Solarmodulen nach der Fertigung zum Feststellen von bereits bei der Fertigung aufgetretenen Leiterbahnunterbrechungen oder auch zur Kontrolle von bereits im Einsatz befindlichen Solarmodulen beispielsweise vor Ablauf der Gewährleistungszeit durch den Kunden besteht daher ein Bedarf nach einer einfach durchzuführenden Überprüfung der Solarmodule auf Leiterbahnunterbrechungen.

Eine derartige Vorrichtung und ein derartiges Verfahren sind aus der DE-U-93 12 710 bekannt. Gemäß dieser Druckschrift wird bei einer entsprechend ausgebildeten Vorrichtung ein eine Induktivität sowie Mittel zur Schwingungsanregung ausweisender aktiver Resonanzkreis mit Anschlüssen von Solarmodulen gekoppelt. Über Energieleitungen des Solarmodules wird ein Meßwertwandler mit dem Resonanzkreis gekoppelt. Der Meßwertwandler wird am Ende der Energieleitungen an einer zentralen Stelle im Bereich einer zentralen Energieaufarbeitung angeschlossen. Zwar sind bei der bekannten Vorrichtung und dem bekannten Verfahren Fehler in aus mehreren Solarmodulen aufgebauten Solaranlagen ohne zusätzlichen Installationsaufwand bei der Verkabelung der Solaranlage erkennbar und innerhalb gewisser Grenzen auch lokalisierbar, allerdings ist aufgrund der angegebenen Verschaltung lediglich eine verhältnismäßig grobe Fehlerlokalisierung möglich.

Für eine derartige Prüfaufgabe befinden sich auch Vorrichtungen im Einsatz, die mit thermischen Detektoren im Bereich von Leiterbahnunterbrechungen häufig, aber nicht ausschließlich aus diesem Grund auftretende Wärmeentwicklungen im Lastbetrieb erfassen sollen. Diese Vorrichtungen weisen jedoch den Nachteil auf, daß sie technisch sehr aufwendig und für eine schnelle Routineüberprüfung von Solarmodulen insbesondere im Lastbetrieb aufgrund der teilweisen Abschattung und damit verbundenen Verfälschung der Meßergebnisse wenig geeignet sind.

Der Erfindung liegt die Aufgabe zugrunde, eine Vorrichtung und ein Verfahren der eingangs genannten Art anzugeben, mit der Fehler in aus mehreren Solarzellen aufgebauten Solarmodulen einer Solaranlage auf einzelne Solarzellen eingrenzbar sind, insbesondere auch wenn mehrere Solarzellen eines Solarmodules defekt sein sollten.

Diese Aufgabe wird mit einer Vorrichtung der eingangs genannten Art erfindungsgemäß dadurch gelöst, daß die wenigstens eine Induktivität so ausgebildet ist, daß sie an eine zwischen zwei benachbarten Solarzellen des Solarmodules ausgebildete Leiterschleife ankoppelbar ist, und daß der Meßwertwandler zum Erfassen von durch die Kopplung an die Leiterschleife beeinflußten Kenngrößen des Resonanzkreises direkt über Abgriffe mit dem Resonanzkreis und den Mitteln zur Schwingungsanregung verbunden ist.

Diese Aufgabe wird mit einem Verfahren der eingangs genannten Art erfindungsgemäß dadurch gelöst, daß der Resonanzkreis mit einer zwischen zwei benachbarten Solarzellen des Solarmodules ausgebildeten Leiterschleife gekoppelt und durch die Kopplung mit der Leiterschleife verursachte, von dem Scheinwiderstand der Leiterschleife abhängige Änderungen der Oszillationseigenschaften des Resonanzkreises direkt über Abgriffe am Resonanzkreis erfaßt werden.

Dadurch, daß bei der erfindungsgemäßen Vorrichtung und dem erfindungsgemäßen Verfahren nunmehr Änderungen der Oszillationseigenschaften des mit einer zwischen zwei benachbarten Solarzellen des Solarmodules ausgebildeten Leiterschleife gekoppelten Resonanzkreises über direkte Verschaltung des Meßwertwandlers mit dem Resonanzkreis erfaßt werden, sind Leiterbahnunterbrechungen auf den Bereich einzelner Solarzellen eingrenzbar, da lediglich der lokale Scheinwiderstand der Leiterschleife auf den Resonanzkreis einwirkt.

Gemäß der Erfindung sind somit zur Detektion von Leiterbahnunterbrechungen bei Solarmodulen Wechselwirkungseigenschaften von Solarzellen des Solarmodules mit leitungsfrei angekoppelten Schaltkreisen ausgenutzt, die zu Änderungen von Kenngrößen des angekoppelten Schaltkreises in Abhängigkeit davon führen, ob zwischen Solarzellen Leiterbahnunterbrechungen vorliegen oder nicht.

Durch die induktive Kopplung einer in einem Resonanzkreis integrierten Induktivität an eine zwischen zwei benachbarten Solarzellen des Solarmodules ausgebildete Leiterschleife sind bei der erfindungsgemäßen Vorrichtung und dem erfindungsgemäßen Verfahren die Kenngrößen des Resonanzkreises von dem Scheinwiderstand der Leiterschleife abhängig, so daß mit verhältnismäßig geringem technischen Aufwand durch Leiterbahnunterbrechungen hervorgerufene Änderungen von Kenngrößen über den Meßwertwandler erfaßbar sind, ohne daß eine auch nur geringe Belastung des Solarmodules notwendig ist.

In einer Ausgestaltung der erfindungsgemäßen Vorrichtung ist der Resonanzkreis an einen Wechselspannungsgenerator angeschlossen.

In einer Weiterbildung der vorgenannten Ausgestaltung der erfindungsgemäßen Vorrichtung sind bei dem Resonanzkreis die Induktivität und die Kapazität in Reihe geschaltet.

Bei einer anderen Weiterbildung der vorgenannten Ausgestaltung sind bei dem Resonanzkreis die Induktivität und die Kapazität parallel geschaltet.

Bei einer weiteren Ausgestaltung der erfindungsgemäßen Vorrichtung ist der Resonanzkreis ein Schwingkreis mit einer parallel zu einer Kapazität geschalteten Induktivität sowie einer Steuereinheit.

In einer weiteren Ausgestaltung der erfindungsgemäßen Vorrichtung ist der Resonanzkreis ein Schwingkreis mit einer in Reihe zu einer Kapazität geschalteten Induktivität sowie einer Steuereinheit.

Bei den vorgenannten Ausgestaltungen und Weiterbildungen ist es vorteilhaft, daß der Meßwertwandler ein Strommeßgerät ist.

Weiterhin ist bei den vorgennanten Ausgestaltungen und Weiterbildungen zweckmäßig, daß an den Meßwertwandler Anzeigemittel angeschlossen sind, mit denen eine Leiterbahnunterbrechung in der Leiterschleife optisch und/oder akustisch anzeigbar ist.

Bei einer Ausgestaltung des erfindungsgemäßen Verfahrens wird zweckmäßigerweise die Änderung des in dem Resonanzkreis fließenden Stromes erfaßt.

Weitere zweckmäßige Ausgestaltungen und Vorteile der Erfindung sind Gegenstand der Unteransprüche sowie der nachfolgenden Beschreibung von Ausführungsbeispielen unter Bezug auf die Figuren der Zeichnung. Es zeigen:
- Fig. 1: einen Ausschnitt aus einem mit aus einzelnen Solarzellen aufgebauten Solarmodul im Schnitt,
- Fig. 2: mehrere mit Leiterbahnen verbundene Solarzellen des Solarmodules gemäß Fig. 1 in einer perspektivischen Darstellung,
- Fig. 3: die Anordnung gemäß Fig. 2 mit typischen Leiterbahnunterbrechungen,
- Fig. 4: eine Vorrichtung zur Detektion von Leiterbahnunterbrechungen bei Solarmodulen mit einem Parallelresonanzkreis in einem Blockschaltbild,
- Fig. 5: eine Vorrichtung zur Detektion von Leiterbahnunterbrechungen bei Solarmodulen mit einem Serienresonanzkreis in einem Blockschaltbild,
- Fig. 6: eine Vorrichtung zur Detektion von Leiterbahnunterbrechungen bei Solarmodulen mit einem Schwingkreis in einem Blockschaltbild,
- Fig. 7 bis Fig. 9: Ausführungsbeispiele von Resonanzkreisinduktivitäten in perspektivischen Darstellungen.

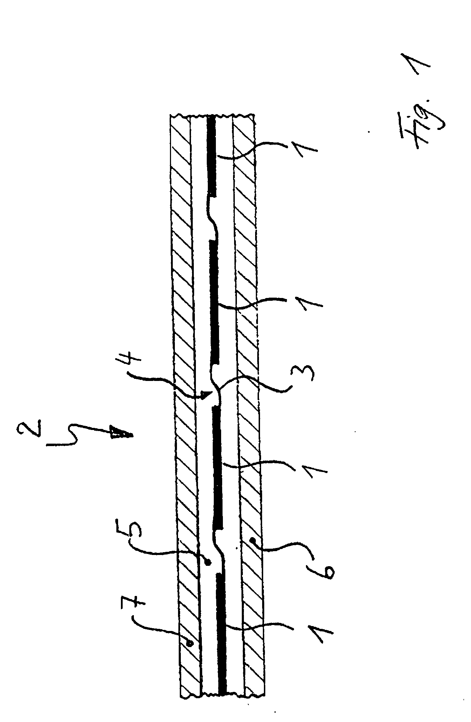

Fig. 1 zeigt ein aus mehreren einzelnen Solarzellen 1 aufgebautes Solarmodul 2 in einer geschnittenen Seitenansicht. Die einzelnen Solarzellen 1 sind über eine erste Leiterbahn 3 und eine zweite Leiterbahn 4 elektrisch miteinander verbunden. Die Leiterbahnen 3, 4 sind verhältnismäßig dünn und somit sehr empfindlich gegenüber mechanischen Belastungen. Die Solarzellen 1 sind in einem transparenten Füllstoff 5 eingebettet, der beidseitig mit einer rückseitigen ersten Glasplatte 6 und einer von einfallender Strahlung beaufschlagbaren zweiten Glasplatte 7 oder in Abwandlungen mit Kunststoffolien bedeckt ist.

Derartig aufgebaute Solarmodule 2 sind im Dauerbetrieb sehr zuverlässig, allerdings kommt es beispielsweise aufgrund von Fertigungsfehlern oder unsachgemäßer Handhabung bei Transport und Einbau mitunter zu Unterbrechungen von Leiterbahnen 3, 4, die beispielsweise bei Haarrissen aufgrund verhältnismäßig hoher elektrischer Feldstärken zu Lichtbögen und großflächigeren Schädigungen aufgrund Wärmeentwicklung führen.

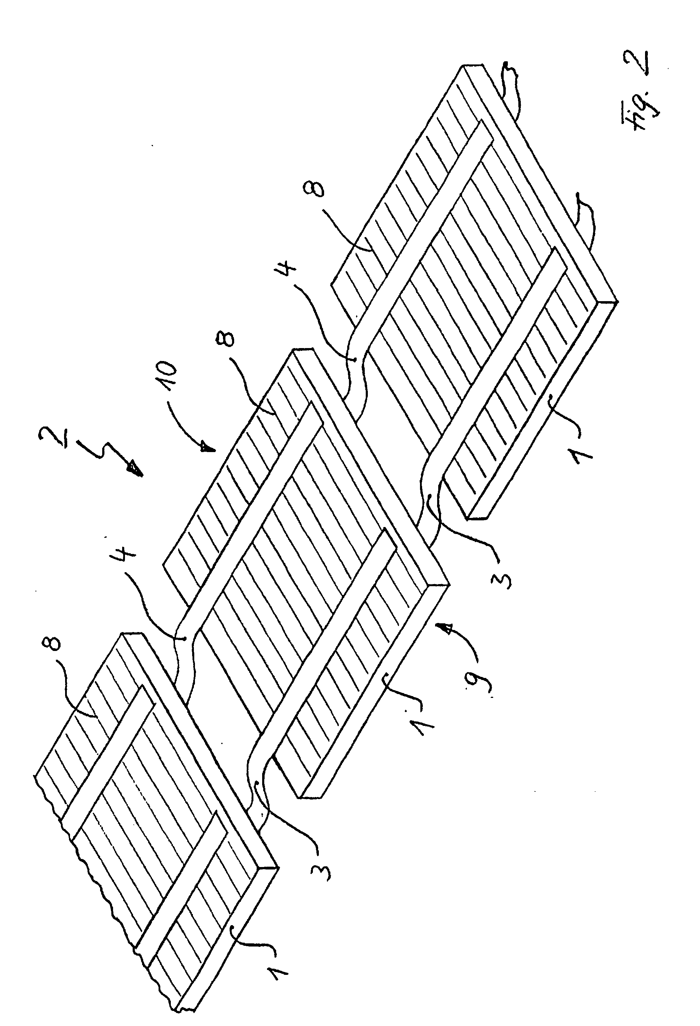

Fig. 2 zeigt eine Anzahl von Solarzellen 1 eines Solarmodules 2 gemäß Fig. 1 in einer perspektivischen Darstellung. Die Solarzellen 1 weisen mehrere aneinandergrenzende Streifenleiter 8 auf, die der Sammlung und Ableitung von durch einfallende Strahlung erzeugten Ladungsträgern dienen. In der Regel sind die Solarzellen 1 auf ihrer von der einfallenden Strahlung abgewandten Unterseite 9 vollflächig metallisiert, wobei die quer zu den Streifenleitern 8 verlaufenden und mit diesen elektrisch kontaktierten Leiterbahnen 3, 4 an einer Randseite einer Solarzelle 1 von der Unterseite 9 auf die Oberseite 10 durchgeführt sind, so daß die einzelnen Solarzellen 1 innerhalb eines Solarmodules 2 elektrisch in Reihe geschaltet sind.

Zwischen zwei benachbarten Solarzellen 1 ist jeweils eine Leiterschleife 11 gebildet, die sich aus den zwischen Solarzellen 1 verlaufenden Abschnitten der Leiterbahnen 3, 4 sowie den randseitigen Streifenleitern 8 zusammensetzen. Die Leiterschleifen 11 weisen im fehlerfreien Zustand einen Scheinwiderstand auf, der in erster Linie aus dem durch die im Vergleich zu den Leiterbahnen relativ hochohmigen Streifenleiter 8 gebildeten ohmschen Widerstand und einem induktiven Blindwiderstand zusammengesetzt ist.

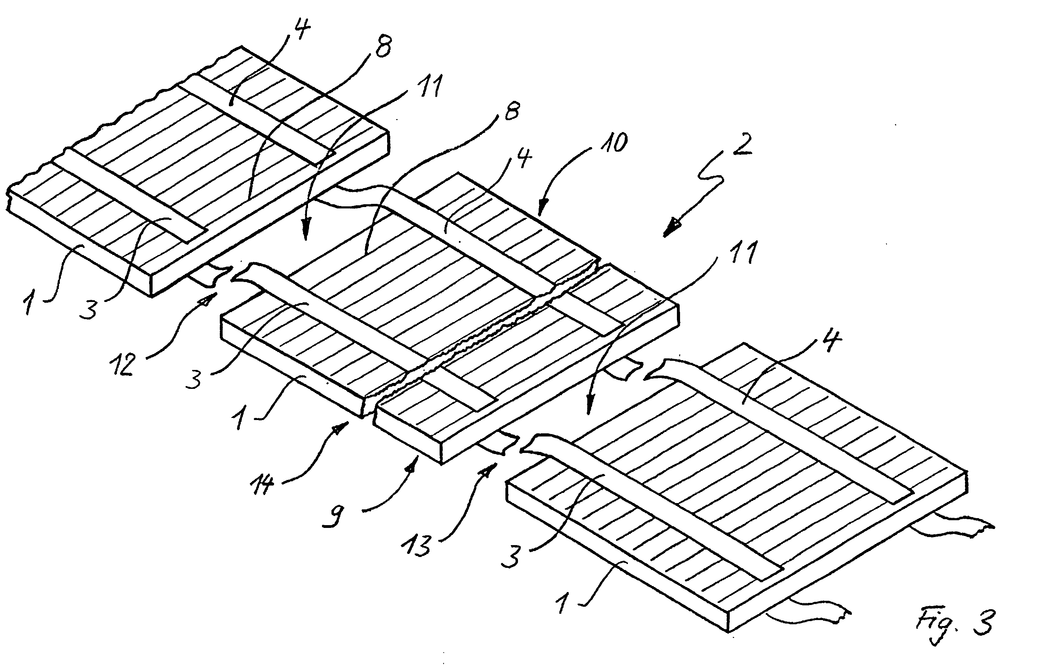

Fig. 3 zeigt die Anordnung gemäß Fig. 2 mit einigen typischen Leiterbahnunterbrechungen. Zwischen den beiden in der Darstellung gemäß Fig. 3 linken Solarzellen 1 ist eine die erste Leiterbahn 3 unterbrechende einseitige Leiterbahnunterbrechung 12 gezeigt. Weiterhin sind die in der Darstellung gemäß Fig. 3 beiden rechten Solarzellen 1 aufgrund einer beide Leiterbahnen 3, 4 unterbrechenden doppelseitigen Leiterbahnunterbrechung 13 elektrisch vollkommen voneinander getrennt. Schließlich ist bei der in der Darstellung gemäß Fig. 3 mittleren Solarzelle 1 ein längs der Streifenleiter 8 und damit quer zu der Solarzelle 1 verlaufender Zellbruch 14 als Leiterbahnunterbrechung dargestellt, der wie die doppelte Leiterbahnunterbrechung 13 beide Leiterbahnen 3, 4 vollständig unterbricht.

Durch einseitige Leiterbahnunterbrechungen 12 oder doppelseitige Leiterbahnunterbrechungen 13 ändert sich der aus dem ohmschen Widerstand und dem induktiven Blindwiderstand zusammengesetzte Scheinwiderstand der Leiterschleife 11.

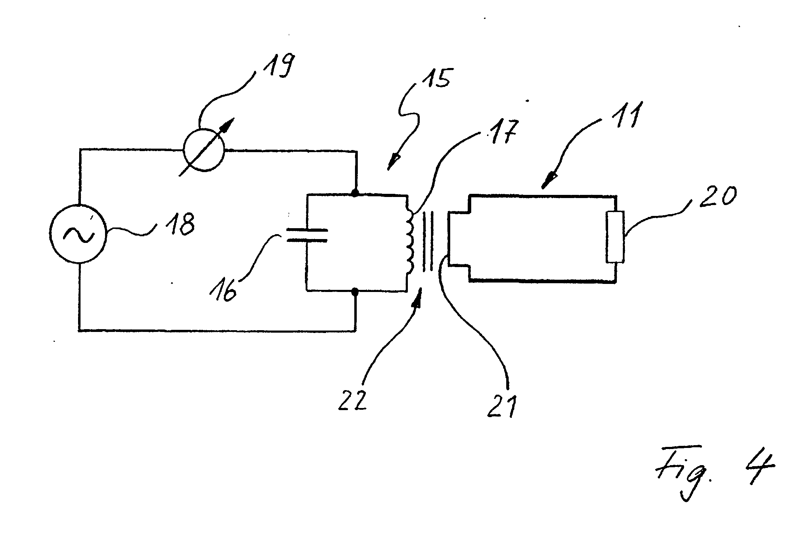

Fig. 4 zeigt in einem Blockschaltbild eine Vorrichtung zur Detektion von Leiterbahnunterbrechungen 12, 13 mit einem als Parallelresonanzkreis 15 ausgebildeten passiven Resonanzkreis. Der Parallelresonanzkreis 15 ist in dem in Fig. 4 dargestellten Ausführungsbeispiel aus einem Parallelkondensator 16 als Kapazität und einer Parallelspule 17 als Induktivität aufgebaut, die parallel geschaltet sind. Der Parallelresonanzkreis 15 ist an einen Wechselspannungsgenerator 18 angeschlossen, mit dem eine Wechselspannung mit einer im steilen Flankenbereich der Scheinwiderstandskennlinie des Parallelresonanzkreises 15 liegenden Frequenz erzeugbar ist. Zwischen dem Parallelresonanzkreis 15 und dem Wechselspannungsgenerator 18 ist als Meßwertwandler eine Strommeßeinheit 19 geschaltet.

Zur Detektion von Leiterbahnunterbrechungen 12, 13 bei Solarmodulen 2 ist die Resonanzkreisspule 17 im Bereich der in Fig. 4 mit einem ohmschen Widerstandssymbol 20 und einem Induktivitätssymbol 21 dargestellte Leiterschleife 11 angeordnet, so daß zwischen der Leiterschleife 11 und dem Parallelresonanzkreis 15 eine durch parallele Striche 22 dargestellte induktive Kopplung auftritt.

Die Gesamtkennlinie des induktiv mit der Leiterschleife 11 gekoppelten Parallelresonanzkreises 15 ist von dem ohmschen Widerstand und dem induktiven Blindwiderstand der Leiterschleife 11 abhängig. Mit der Strommeßeinheit 19 sind über in Fig. 4 nicht dargestellte Anzeigemittel Änderungen in dem ohmschen Widerstand und/oder dem induktiven Blindwiderstand der Leiterschleife 11 bei Leiterunterbrechungen 12, 13 im Vergleich zu den entsprechend Werten bei fehlerfreien Leiterschleifen 11 anzeigbar, indem über die induktive Kopplung in den Parallelresonanzkreis 15 insbesondere im Bereich steiler Kennlinienflanken bereits geringfügige Änderungen des Scheinwiderstandes der Leiterschleife 11 zu deutlichen Änderungen der in dem durch den Parallelresonanzkreis 15 und den Wechselspannungsgenerator 18 gebildeten Stromkreis fließenden Ströme hervorrufen.

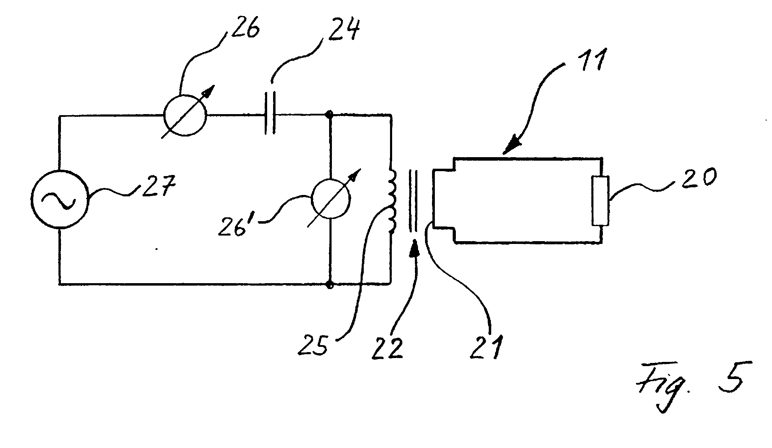

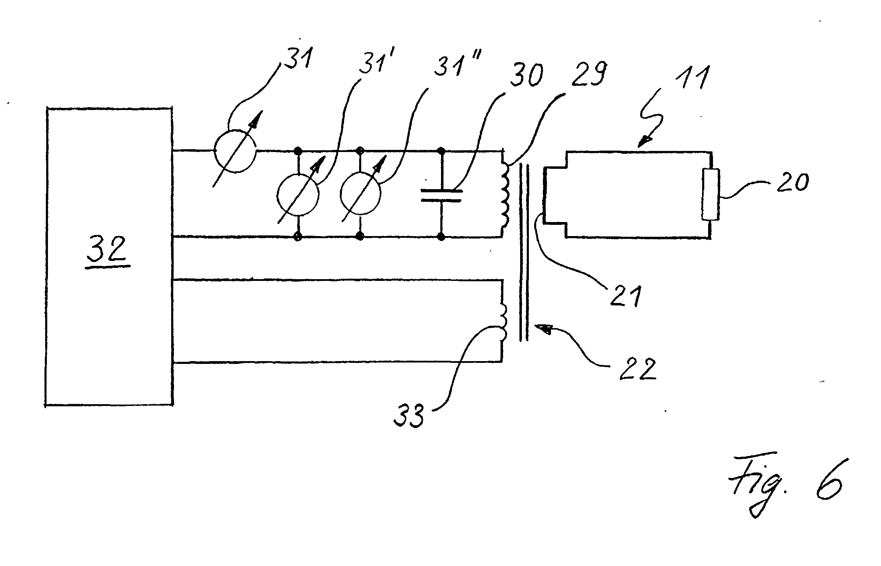

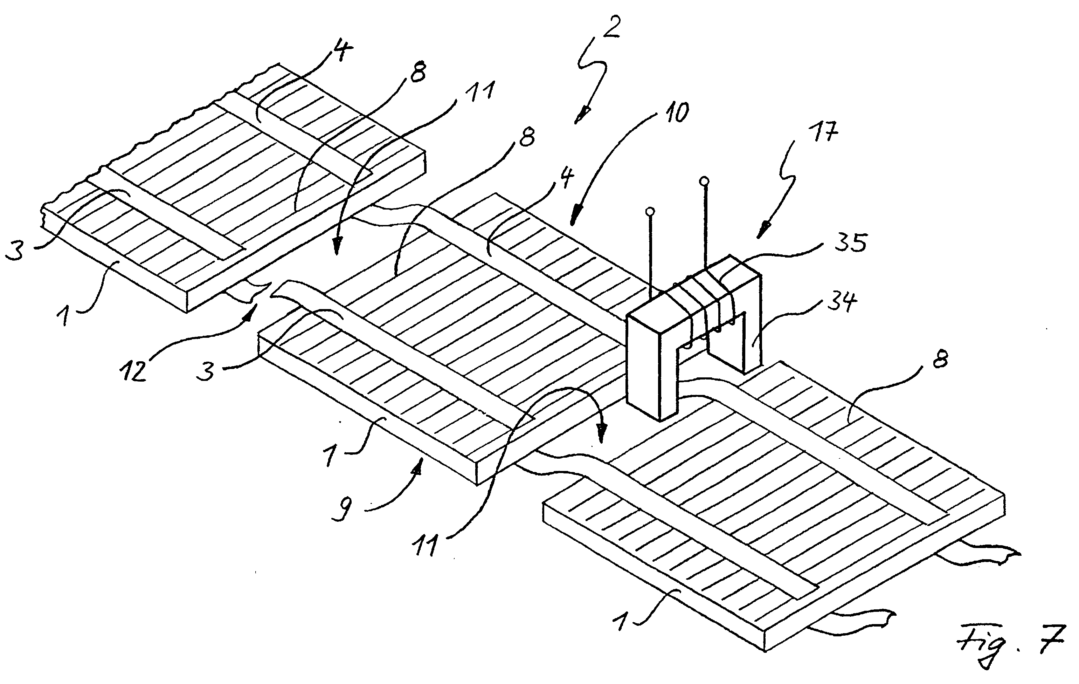

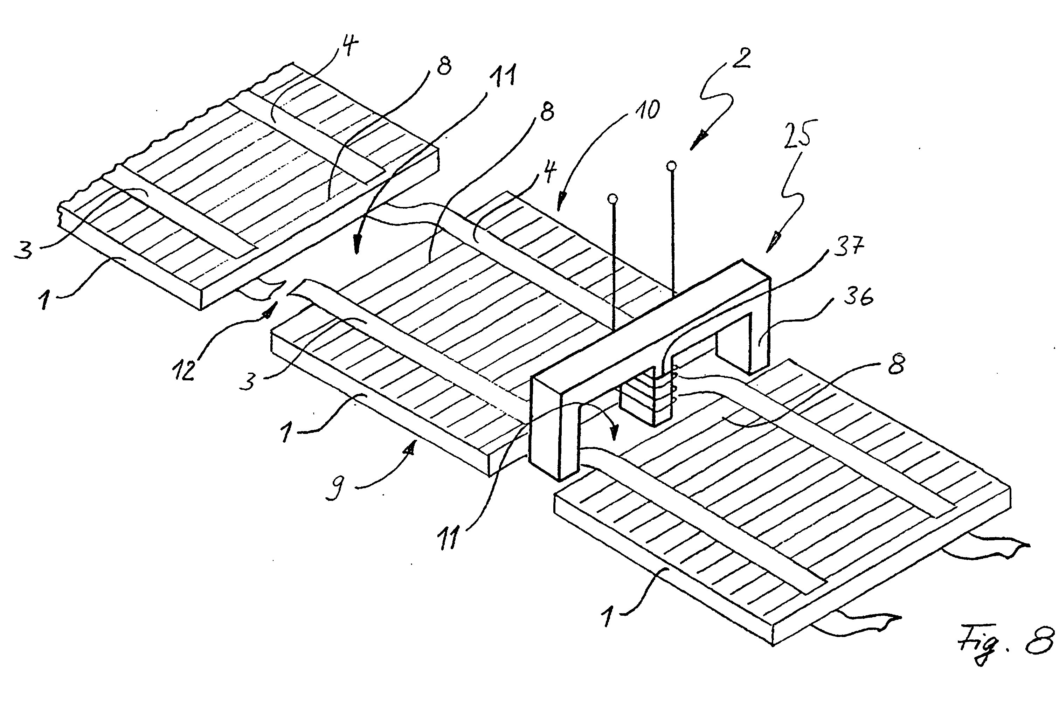

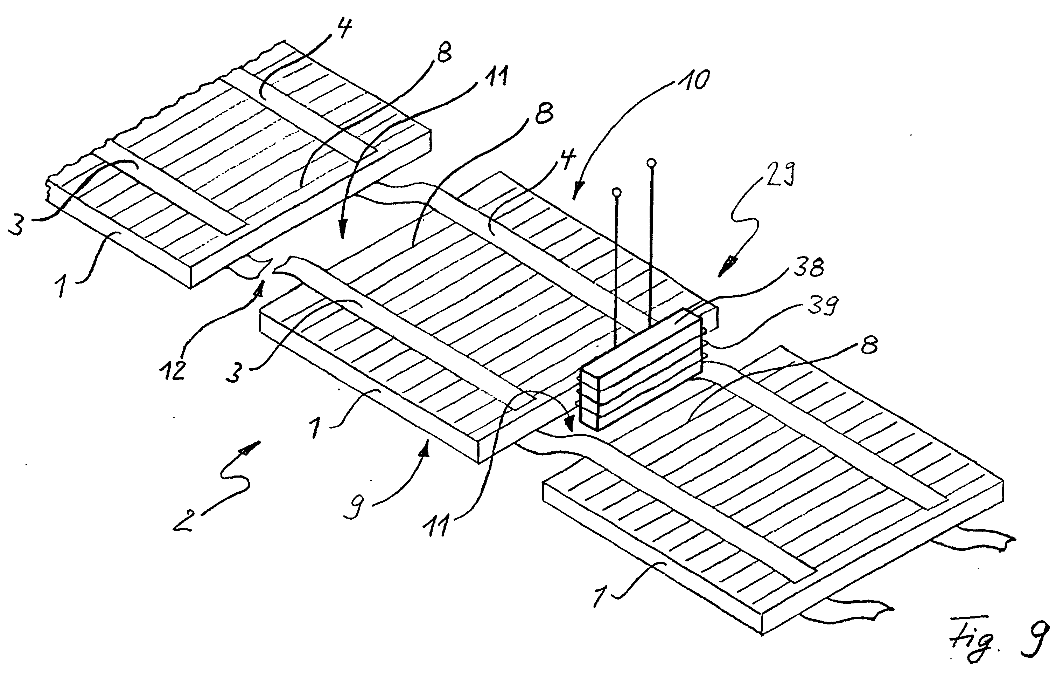

Fig. 5 zeigt in einem Blockschaltbild ein weiteres Ausführungsbeispiel einer Vorrichtung zur Detektion von Leiterbahnunterbrechungen bei Solarmodulen 2 mit einem als Serienresonanzkreis 23 ausgebildeten Resonanzkreis, der aus einer in Reihe zu einem Serienkondensator 24 als Kapazität geschalteten Serienspule 25 als Induktivität aufgebaut ist. Der Serienresonanzkreis 23 ist entsprechend dem Parallelresonanzkreis 15 über eine Strommeßeinheit 26 mit in Fig. 5 nicht dargestellten Anzeigemitteln an einen Wechselspannungsgenerator 27 angeschlossen. Weiterhin ist eine parallel zu der Serienspule 25 geschaltete Spannungsmeßeinheit 26' vorgesehen, mit der als Kenngröße die an der Serienspule 25 abfallende Spannung meßbar ist.

In der Darstellung gemäß Fig. 5 ist der Serienresonanzkreis 23 induktiv entsprechend der Darstellung gemäß Fig. 4 an eine Leiterschleife 11 gekoppelt. Mit dem Wechselspannungsgenerator 27 ist eine Wechselspannung mit einer Frequenz erzeugbar, die im Bereich des steilsten Flankenabschnittes der Scheinwiderstandskennlinie bei Kopplung des Serienresonanzkreises 23 mit einer fehlerfreien Leiterschleife 11 liegt. Bei Änderungen des Scheinwiderstandes der Leiterschleife 11 durch Leiterunterbrechungen 12, 13 verschiebt sich die Kennlinie, so daß mit der Strommeßeinheit 26 und/oder der Spannungsmeßeinheit 26' mit in Fig. 5 nicht dargestellten Anzeigemitteln Leiterunterbrechungen 12, 13 detektierbar sind.

Fig. 6 zeigt ein weiteres Ausführungsbeispiel einer Vorrichtung zur Detektion von Leiterbahnunterbrechungen bei Solarmodulen 2 in einem Blockschaltbild, die als Resonanzkreis einen Schwingkreis 28 aufweist. Der Schwingkreis 28 verfügt über eine induktiv an die Leiterschleife 11 ankoppelbare Schwingkreisspule 29, die parallel zu einer Schwingkreiskapazität 30 geschaltet ist. Die parallel geschaltete Schwingkreisspule 29 und Schwingkreiskapazität 30 sind über eine Strommeßeinheit 31 an eine Ansteuereinheit 32 angeschlossen. An die Schwingkreisspule 29 ist wie durch die parallelen Striche 22 gekennzeichnet induktiv eine Rückkoppelspule 33 gekoppelt, die als Rückkoppelelement zur Anregung der Schwingung ebenfalls an die Ansteuereinheit 32 angeschlossen ist. Mittels der Ansteuereinheit 32 ist der Schwingkreis 28 im Leerlauf im Bereich der Resonanzfrequenz betrieben.

Bei induktiver Kopplung an eine Leiterschleife 11 ist der Schwingkreis 28 in Abhängigkeit des Scheinwiderstandes der Leiterschleife 11 unter Verschiebung der Resonanzfrequenz mit entsprechender Änderung der in dem Resonanzkreis 28 fließenden Ströme gedämpft, wobei mit der Strommeßeinheit 31 über in Fig. 6 nicht dargestellte Anzeigemittel zum Detektieren von Leiterbahnunterbrechungen 12, 13 bei Änderung des Scheinwiderstandes der Leiterschleife 11 die dadurch verursachte Stromänderung anzeigbar ist, wobei durch den Betrieb des Schwingkreises 28 im Bereich der Resonanzfrequenz sich bereits geringfügige Änderungen in der Bedämpfung in merklichen Stromänderungen niederschlagen. Neben einer Änderung des Stromes sind mittels einer parallel geschalteten Spannungsmeßeinheit 31' die Änderung der Schwingungsamplitude in dem Resonanzkreis und/oder mittels einer parallel geschalteten Frequenzmeßeinheit 31" Änderungen der Frequenz als weitere Kenngrößen erfaßbar.

Bei einem nicht dargestellten Ausführungsbeispiel einer Vorrichtung zur Detektion von Leiterbahnunterbrechungen bei Solarmodulen 2 ist als Resonanzkreis ein Schwingkreis vorgesehen, der eine induktiv an die Leiterschleife 11 ankoppelbare Reihenschwingkreisspule aufweist, zu der in Reihe eine Reihenschwingkreiskapazität geschaltet ist. Die Reihenschwingkreisspule und Reihenschwingkreiskapazität sind entsprechend dem mit Bezug auf Fig. 6 beschriebenen Ausführungsbeispiel an Meßwertwandler angeschlossen, um durch die Kopplung an die Leiterschleife 11 beeinflußte Kenngrößen des Schwingkreises zu erfassen.

Fig. 7 zeigt in einer perspektivischen Darstellung eine Ausführung der Parallelspule 17 als Beispiel für die Induktivität des Parallelresonanzkreises 15. Die Parallelspule 17 ist aus einem U-förmigen Spulenkern 34 sowie einer um die Basis des U-förmigen Spulenkerns 34 gelegten Spulenwicklung 35 aufgebaut. In der Darstellung gemäß Fig. 7 ist die Parallelspule 17 so im Bereich eines sich zwischen zwei benachbarten Solarzellen 1 erstreckenden Abschnittes der zweiten Leiterbahn 4 angeordnet, daß diese mit ihrem sich zwischen zwei Solarzellen 1 erstreckenden Abschnitt zwischen den Enden des U-förmigen Spulenkernes 34 erstreckt, so daß eine gute induktive Kopplung mit der zugehörigen Leiterschleife 11 hergestellt ist.

Fig. 8 zeigt eine weitere Ausgestaltung beispielsweise der Serienspule 25 des Serienresonanzkreises 23 gemäß dem in Zusammenhang mit Fig. 5 erläuterten Ausführungsbeispiel als Induktivität, die aus einem E-förmigen Spulenkern 36 sowie einer um den mittleren Schenkel des E-förmigen Spulenkernes 36 gelegten Spulenwicklung 37 aufgebaut ist. In der Darstellung gemäß Fig. 8 ist der E-förmige Spulenkern 36 so angeordnet, daß sowohl die erste Leiterbahn 3 als auch die zweite Leiterbahn 4 in ihren sich zwischen zwei benachbarten Solarzellen erstreckenden Abschnitten zwischen zwei benachbarten Enden des E-förmigen Spulenkernes 36 verlaufen. Bei dieser Ausgestaltung ist eine besonders gute induktive Kopplung mit der Leiterschleife 11 erzielt.

Fig. 9 zeigt in einer perspektivischen Darstellung als Ausgestaltung einer Induktivität für den Schwingkreis 28 die Schwingkreisspule 29 gemäß dem in Zusammenhang mit Fig. 6 erläuterten Ausführungsbeispiel, die aus einem quaderförmigen Spulenkern 37 mit einer den quaderförmigen Spulenkern 37 umgebenden Spulenwicklung 38 aufgebaut ist. Zum Hervorrufen der induktiven Kopplung mit einer Leiterschleife 11 ist wie in Fig. 9 dargestellt die Schwingkreisspule 29 zwischen zwei sich zwischen benachbarten Solarzellen 1 erstreckenden Abschnitten der Leiterbahnen 3, 4 anzuordnen.

Selbstverständlich sind die anhand Fig. 7, Fig. 8 und Fig. 9 erläuterten Ausgestaltungen von Induktivitäten jeweils auch bei den in Zusammenhang mit den einzelnen Figuren nicht erläuterten Resonanzkreisen 15, 23 beziehungsweise bei dem Schwingkreis 28 verwendbar.

## Patentansprüche

1. Vorrichtung zur Detektion von Leiterbahnunterbrechungen (12, 13) bei Solarmodulen (2) mit einem wenigstens eine an Solarmodule (2) induktiv ankoppelbare Induktivität (17, 25, 29, 33) sowie Mittel (18, 27, 32) zur Schwingungsanregung aufweisenden Resonanzkreis (15, 23, 28) und mit einem an den Resonanzkreis (15, 23, 28) gekoppelten Meßwertwandler (19, 26, 26', 31, 31', 31"), **dadurch gekennzeichnet, daß** die wenigstens eine Induktivität (17, 25, 29) so ausgebildet ist, daß sie an eine zwischen zwei benachbarten Solarzellen (1) des Solarmodules (2) ausgebildete Leiterschleife (11) ankoppelbar ist, und daß der Meßwertwandler (19, 26, 26', 31, 31', 31") zum Erfassen von durch die Kopplung an die Leiterschleife (11) beeinflußten Kenngrößen des Resonanzkreises (15, 23, 28) direkt über Abgriffe mit dem Resonanzkreis (15, 23, 28) und den Mitteln (18, 27, 32) zur Schwingungsanregung verbunden ist.

2. Vorrichtung nach Anspruch 1, **dadurch gekennzeichnet, daß** der Resonanzkreis (15, 23) an einen Wechselspannungsgenerator (18, 27) angeschlossen ist.

3. Vorrichtung nach Anspruch 2, **dadurch gekennzeichnet, daß** bei dem Resonanzkreis (15) die Induktivität (25) und die Kapazität (24) in Reihe geschaltet sind.

4. Vorrichtung nach Anspruch 2, **dadurch gekennzeichnet, daß** bei dem Resonanzkreis (23) die Induktivität (25) und die Kapazität (24) parallel geschaltet sind.

5. Vorrichtung nach Anspruch 1, **dadurch gekennzeichnet, daß** der Resonanzkreis ein Schwingkreis (28) mit einer parallel zu einer Kapazität (30) geschalteten Induktivität (29) sowie einer Steuereinheit (32) ist.

6. Vorrichtung nach Anspruch 1, **dadurch gekennzeichnet, daß** der Resonanzkreis ein Schwingkreis mit einer in Reihe zu einer Kapazität geschalteten Induktivität sowie einer Steuereinheit ist.

7. Vorrichtung nach einem der Ansprüche 1 bis 6, **dadurch gekennzeichnet, daß** der Meßwertwandler ein Strommeßgerät (19, 26, 31) ist.

8. Vorrichtung nach einem der Ansprüche 1 bis 7, **dadurch gekennzeichnet, daß** an den Meßwertwandler (19, 26, 31) Anzeigemittel angeschlossen sind, mit der eine Leiterbahnunterbrechung (12, 13) in der Leiterschleife (11) optisch und/oder akustisch anzeigbar ist.

9. Verfahren zur Detektion von Leiterbahnunterbrechungen (12, 13) bei Solarmodulen (2), bei dem ein Resonanzkreis (15, 23, 28) induktiv mit einem Solarmodul (2) gekoppelt wird, **dadurch gekennzeichnet, daß** der Resonanzkreis (15, 23, 28) mit einer zwischen zwei benachbarten Solarzellen (1) des Solarmodules (2) ausgebildeten Leiterschleife (11) gekoppelt und durch die Kopplung mit der Leiterschleife (11) verursachte, von dem Scheinwiderstand der Leiterschleife (11) abhängige Änderungen der Oszillationseigenschaften des Resonanzkreises (15, 23, 28) direkt über Abgriffe am Resonanzkreis (15, 23, 28) erfaßt werden.

10. Verfahren nach Anspruch 9, **dadurch gekennzeichnet, daß** die Änderung des in dem Resonanzkreis (15, 23, 28) fließenden Stromes erfaßt wird.

## Claims

1. Device for the detection of strip conductor breaks (12, 13) in the case of solar modules (2) with a resonant circuit (15, 23, 28) which has at least one inductive resistor (17, 25, 29, 33) which can be inductively coupled to solar modules (2) as well as means (18, 27, 32) for excitation of vibrations, and with a measured value converter (19, 26, 26', 31, 31', 31") coupled to the resonant circuit (15, 23, 28),
**characterised in that**
the at least one inductive resistor (17, 25, 29) is designed such that it can be coupled to a conductor loop (11) which is developed between two neighbouring solar cells (1) of the solar module (2); and that the measured value converter (19, 26, 26', 31, 31', 31"), for the recording of characteristic values of the resonant circuit (15, 23, 28) which are influenced by the coupling to the conductor loop (11), is directly connected via taps to the resonant circuit (15, 23, 28) and the means (18, 27, 32) for excitation of vibrations.

2. Device in accordance with claim 1, **characterised in that** the resonant circuit (15, 23) is connected to an alternating voltage generator (18, 27).

3. Device in accordance with claim 2, **characterised in that** in the case of the resonant circuit (15), the inductive resistor (25) and the capacitor (24) are switched in series.

4. Device in accordance with claim 2, **characterised in that** in the case of the resonant circuit (23), the inductive resistor (25) and the capacitor (24) are switched in parallel.

5. Device in accordance with claim 1, **characterised in that** the resonant circuit is an oscillation circuit (28) which has an inductive resistor (29) switched parallel to a capacitor (30) as well as a control unit (32).

6. Device in accordance with claim 1, **characterised in that** the resonant circuit is an oscillation circuit which has an inductive resistor switched in series to a capacitor, as well as a control unit.

7. Device in accordance with one of the claims 1 to 6, **characterised in that** the measured value converter is a current meter device (19, 26, 31).

8. Device in accordance with one of the claims 1 to 7, **characterised in that** connected to the measured value converter (19, 26, 31) are indicator devices with which it is possible to indicate optically and/or acoustically any strip conductor break (12, 13) in the conductor loop (11).

9. Method for the detection of strip conductor breaks (12, 13) in the case of solar modules (2), in which a resonant circuit (15, 23, 28) is inductively coupled to a solar module (2),
**characterised in that**
the resonant circuit (15, 23, 28) [is] coupled to a conductor loop (11) developed between two neighbouring solar cells (1) of the solar module (2), and changes in the oscillation characteristics of the resonant circuit (15, 23, 28) caused by the coupling with the conductor loop (11) and dependant on the impedance of the conductor loop (11) are detected directly via taps on the resonant circuit (15, 23, 28).

10. Method in accordance with claim 9, **characterised in that** the change in the current flowing in the resonant circuit (15, 23, 28) is detected.

## Revendications

1. Dispositif de détection de ruptures de pistes conductrices (12,13) dans les modules solaires (2) comprenant un circuit résonant (15,23,28) présentant au moins une inductance (17,25,29,33) pouvant être reliée par couplage inductif à des modules solaires (2) ainsi que des moyens (18,27,32) d'excitation d'oscillateur, et comprenant également un dispositif de mesure (19,26,26',31,31',31") couplé au circuit résonant (15,23,28), **caractérisé en ce que** la une au moins inductance (17,25,29) est configurée pour pouvoir être couplée à une boucle conductrice (11) formée entre deux cellules solaires (1) adjacentes du module solaire (2), et **en ce que** le dispositif de mesure (19,26,26',31,31',31")est relié directement par des branchements au circuit résonant (15,23,28) et aux moyens (18,27,32) d'excitation d'oscillateur pour la détection de valeurs caractéristiques du circuit résonant (15,23,28) en fonction du couplage à la boucle conductrice (11).

2. Dispositif selon la revendication 1, **caractérisé en ce que** le circuit résonant (15,23) est relié à un générateur de courant alternatif (18,27).

3. Dispositif selon la revendication 2, **caractérisé en ce que** dans le circuit résonant (15), l'inductance (25) et la capacité (24) sont montées en série.

4. Dispositif selon la revendication 2, **caractérisé en ce que** dans le circuit résonant (23), l'inductance (25) et la capacité (24) sont montées en parallèle.

5. Dispositif selon la revendication 1, **caractérisé en ce que** le circuit résonant est un circuit oscillant (28) comprenant une inductance montée en parallèle avec une capacité (30) ainsi qu'une unité de commande (32).

6. Dispositif selon la revendication 1, **caractérisé en ce que** le circuit résonant est un circuit oscillant comprenant une inductance montée en série avec une capacité ainsi qu'une unité de commande.

7. Dispositif selon l'une quelconque des revendications 1 à 6, **caractérisé en ce que** le dispositif de mesure est un ampèremètre (19,26,31).

8. Dispositif selon l'une quelconque des revendications 1 à 7, **caractérisé en ce que** des moyens d'affichage sont reliés au dispositif de mesure (19,26,31) permettant de signaler de manière optique et/ou acoustique une rupture de piste conductrice (12,13) dans la boucle conductrice (11).

9. Procédé de détection de ruptures de conducteur (12,13) dans des modules solaires (2), dans lequel un circuit résonant (15,23,28) est relié par couplage inductif à un module solaire (2), **caractérisé en ce que** le circuit résonant (15,23,28) est relié à une boucle conductrice (11) formée entre deux cellules solaires (1) adjacentes du module solaire (2) et **en ce que** des modifications des caractéristiques oscillatoires du circuit résonant (15,23,28) provoquées par le couplage à la boucle conductrice (11) et fonction de la variation d'impédance de la boucle conductrice sont détectées directement par des branchements sur le circuit résonant (15,23,28).

10. Procédé selon la revendication 9, **caractérisé en ce que** l'on détecte la variation du courant circulant dans le circuit résonant (15,23,28).
